# EUROPEAN PATENT SPECIFICATION

(11) **EP 2 093 694 B1**
(45) Date of publication and mention of the grant of the patent: **22.06.2011**
(21) Application number: 09007131.7
(22) Date of filing: 28.12.2000
(51) Int. Cl.: G06K 7/10

(54) **Receiving chamber for a laser reader**
Aufnahmekammer für Laserlesevorrichtungen
Chambre de réception pour lecteur laser

(30) Priority: 26.10.2000 EP 00830707
(43) Date of publication of application: 26.08.2009
(62) Divisional of application: 00830860.3
(73) Proprietor: Datalogic S.p.A., 40012 Lippo di Calderara di Reno (IT)
(72) Inventor: Oliva, Guido Maurizio, 45100 Rovigo (IT); Vonmetz, Kurt, 40122 Bologna (IT); Amorosi, Stefano, 40134 Bologna (IT)
(74) Representative: Riccardi, Elisa

(56) References cited:
- DE-U1- 29 616 565
- US-A- 5 763 866

## Description

The present invention relates to a laser reader, more particularly to a receiving section

Therefor. Known optical code readers can essentially be divided into readers wherein the entire code width is simultaneously illuminated, as through an array of LEDs, and the diffused light is simultaneously collected and detected, as by an array of linear or matrix sensors ("imaging" of the optical code), and readers wherein a laser beam sweeps a certain angle so that a laser spot scans the optical code ("flying spot"), and the diffused light is collected and detected by photo-detecting elements of the photodiode and/or CCD and/or C-MOS type.

The readers of the second type include a laser module for reading optical codes having essentially a source for generating a laser beam of predetermined size and shape, means for generating a scan of the laser beam on the optical code to be read, means for collecting at least a portion of the light diffused by the code, and photo-detecting means for detecting the collected light and converting the detected luminous power into an electrical signal reproducing as accurately as possible the reflectance modulations of the elements forming the code.

DE 296 16 565 U1 and US 5 763 866 A each disclose an imager type optical reader wherein a casing has an L-shape in cross section. A mirror is positioned at 45° with respect to a light input face, and to a photo-detecting element. An imaging lens is arranged between the mirror and the photo-detecting element.

The technical problem at the basis of the present invention is that of providing an even more compact receiving section.

The above problem is solved, according to the invention, by a receiving section according to claim 1. Further advantageous features are recited in the depending claims.

This wedge-like shape of the receiving section is advantageous for various reasons. In fact, the light rays diffused by the code travel a first "horizontal" path from the focusing lens to the internally reflecting surface, and a second "vertical" path from the internally reflecting surface to the photo-detecting elements. It is thus possible to use -depth size being equal- a lens having a longer focal length with respect to a parallelepiped receiving chamber, with the above advantages, or -focal length being equal- it is possible to construct a receiving chamber having a smaller depth, with advantages in terms of compactness of the laser module. Moreover, the "horizontal" arrangement of the photo-detecting elements allows using a single commonly marketed photodiode, having a large area, without adversely affecting the laser module thickness. Moreover, the "horizontal" arrangement of the photo-detecting elements prevents the need of providing a "vertical" printed circuit, on the contrary it is possible to use a single printed circuit also for powering and controlling the scanning illumination section.

Features and advantages of the invention shall now be illustrated with reference to embodiments, shown by way of a non-limiting example, in the attached drawings, wherein:
Fig. 1 schematically shows a perspective, partly broken-away view of a first laser module for reading optical codes;
Fig. 2 shows the preferred signal for powering the laser source of the laser module;
Figures 3A and 3B show an optically reflecting member useful for reading "stacked" codes;
Figures 4A and 4B show the efficiency of different types of focusing lens;
Figures 5A and 5B respectively show the arrangement of photo-detecting elements in the laser module and in a laser module according to the prior art;
Fig. 6 schematically shows an array of photo-detecting elements, and a corresponding array of focusing lenses;
Figures 7A and 7B schematically show two different arrangements of photodiodes for the laser module;
Fig. 8 shows a perspective view of another laser module;
Fig. 9 schematically shows an oscillating motor for the laser module;
Fig, 10 schematically shows another scanning illumination section for the laser module;
Fig. 11 schematically shows still another scanning illumination section for the laser module;
Figures 12 and 13 show perspective top, and respectively bottom views of a support block of the laser module components;
Figures 14 and 15 show perspective views of a support for the laser module motor, respectively with and without housed motor;
Figure 16 schematically shows a further laser module; and
Figures 17 to 19 schematically show alternative embodiments of a receiving section of the laser module.

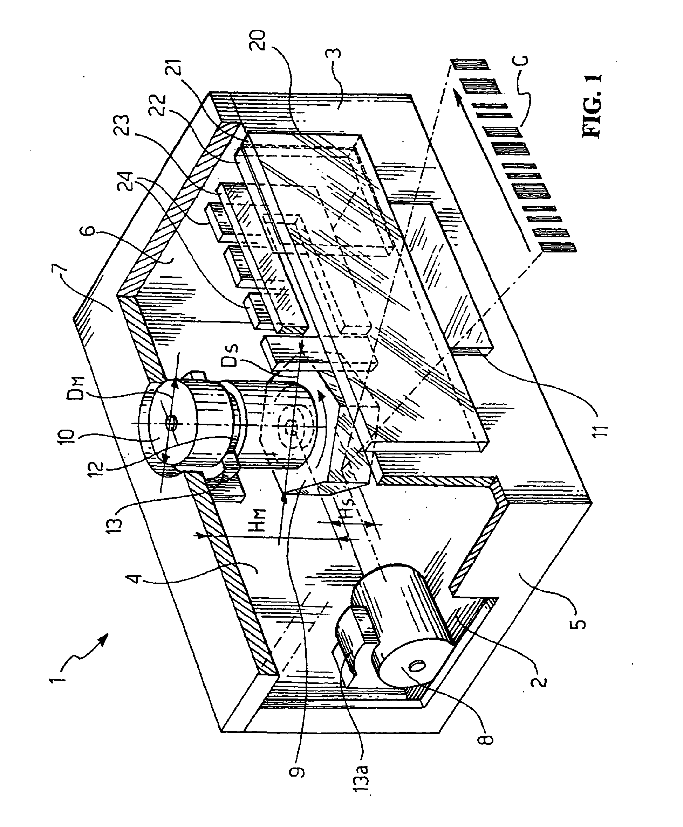

As shown in Figure 1, a laser module 1 exhibits a parallelepiped shape, having a base face or wall 2, a front wall 3, a rear wall 4 erected from the major sides of base 2, side walls 5, 6 and a top wall 7. The size of such a module 1 is comparable to that of a small match box, in any case such as to take up a volume less than 20 cm³.

Firstly, the laser module 1 houses components of a scanning illumination section, consisting of a laser source 8 or emitter, an optically reflecting member 9, made in Figure 1 as a hexagonal right-angled prism having at least a portion of the faces of the side surface that is mirror-like, and a motor 10.

The optically reflecting member or polygonal mirror 9 is rotatively moved by motor 10. The laser beam emitted by emitter 8 is reflected by the reflecting faces of the polygonal mirror 9 according to angles depending on the instant position of the mirror 9 itself, so that the laser beam sweeps a certain angle in a scan plane parallel to the base wall 2 of module 1, exiting from its front wall 3 through an emission window 11. Thus, the laser beam scans the optical code C with a laser spot.

More in particular, the laser emitter 8 is arranged adjacent to the rear wall 4 of module 1 and in the proximity of the polygonal mirror 9, on which it directly emits the laser beam, avoiding any intermediate mirror. This allows minimising the overall dimensions, and simplifying the operations for optically aligning the system.

Preferably, the laser emitter 8 is fastened to the wall through a clip 13a whose shape is complementary to the shape of its outside casing, so that the position of the laser emitter 8 is fixed with respect to the laser module 1.

For improving the rejection to ambient light, the beam generated by the laser emitter 8 can be modulated at a high frequency, for example at about 40 MHz. In this way, it is possible to separate the information contained in the modulated signal, which is the part of interest, from that contained in the non-modulated signal, which is the noise due to ambient light.

Of particular applicative interest, moreover, the laser light can be high frequency modulated so as to allow the optical code reader in which the laser module 1 is included to act as a measurer of the optical code distance from the reader itself, for example as described in European patent application EP 0 652 530 A2,

Motor 10, for example a direct current, brushless or stepping motor, has a cylindrical body whose base has a diameter D_{M} that is less than or equal to 5 mm and whose height H_{M} can be as small as less than 3 mm. The optically reflecting member 9 is mounted on it, preferably directly rotatively coupled to it, and when it is a polygonal mirror it is of a diameter D_{S} less than 7 mm, a height H_{S} of the optically active surface less than 1.5 mm and a mass less than 0.3 g. Such a small size of the polygonal mirror 9 allows obtaining a very small rotating mass and thus, a low inertia, so as to allow mirror 9 to reach the desired revolving speed in a very short time, less than 100 msec.

More in particular, motor 10 and mirror 9 are arranged with the respective axes orthogonal to the base 2 of module 1, and as close as possible to the rear wall 4, so as to originate a scan as far as possible from the emission window 11. Such an arrangement allows the scan line width to be already maximum at the emission window 11, and it thus allows covering the entire width of the optical code C to be read already at a few centimetre distance (about 4 cm) beyond the emission window 11.

Similarly to the laser emitter 8, it is important that the position of motor 10 and optically reflecting member 9 in the laser module 1 is fixed. Motor 10 can thus advantageously be provided with a slit 12 or notch on the cylindrical body, intended for being coupled to a clip 13 protruding from the rear wall 4 of the laser module 1, so that the height of motor 10 is fixed with respect to the laser module 1, thus ensuring the height of the polygonal mirror 9 with respect to the base 2 of laser module 1. Of course, notch 12 and clip 13 are to be construed as merely examplificative of conjugate fastening means.

Motor 10 exhibits a revolving speed that can be continuously varied from a minimum of 750 revolutions/minute to a maximum of 8,000 revolutions/minute, so as to obtain, for example in the case of a polygonal mirror 9 with hexagonal base, scan speeds comprised between 75 and 800 scan/sec. Of course, by varying the number of side faces of the polygonal mirror 9 it is possible to obtain a variation interval shifted upwards or downwards: thus, with a pentagonal-base body, there will be from 62 to 660 scan/sec, whereas with an octagonal-base body, there will be from 100 to 1050 scan/sec.

In order to improve the reading of high-resolution optical codes, or of codes that are far from the laser module 1, advantageously the speed of motor 10 -and therefore, that of the optically reflecting member 9- can be varied in real time. In fact, the effect of a bar code having very narrow bars, as well as that of a code located far away, consists in a bar focusing loss due to the upper limit of the electronics passband. It follows that, even though the laser spot is focused, the signal is attenuated by the limits of the electronics. Traditionally, polygonal-mirror systems have slow response times to the revolving speed variation, but the use of a polygonal mirror 9 having such a small mass allows making its response to the imposed speed variations very fast. In this way, if the code is not read at the first scan, it is possible to reduce the revolving speed, thus "enlarging" the bars, reducing at the same time the operating frequency of the electronics, which thus attenuates less. With a lower attenuation by the electronics, the signal is definitely more focused. Moreover, the adjustment capability can be exploited upon start up, by driving the motor with a ramp signal to reach the operating speed more gradually. In this way, in the case of a particularly difficult code, due to the high resolution, or to the presence of deformations in the bars, it is possible to carry out the first scans at a reduced speed, thus facilitating the decoding.

By using a scan start signal, provided for example in the manner described below, it is possible more in general to perform such a control of the motor as to produce a speed pattern changing from scan to scan, or partly, also within each scan, so as to adjust the reading speed to the application peculiarities and to the processing electronics capabilities.

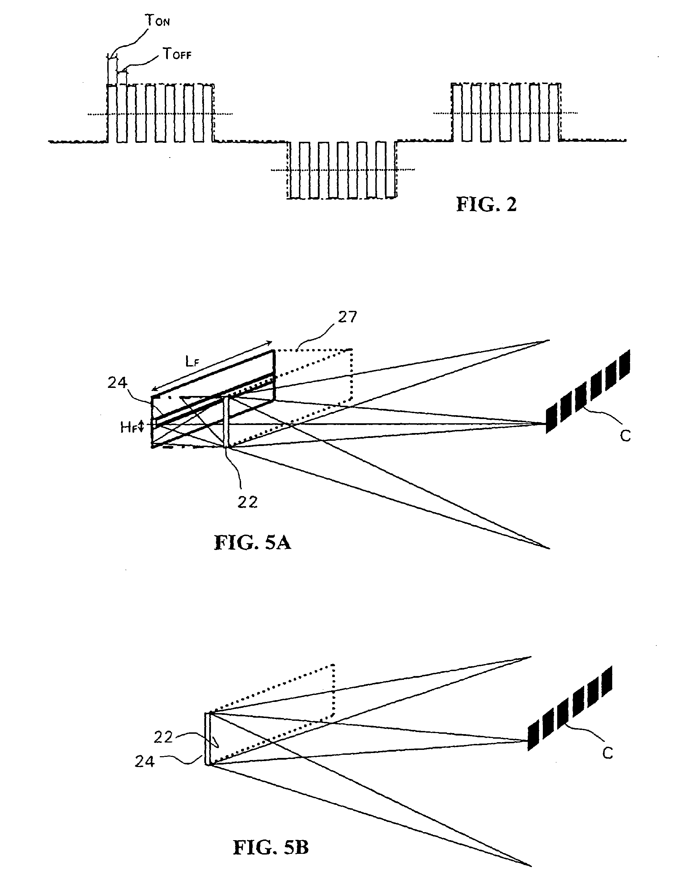

In order to reduce the consumption of motor 10 it is advantageous to use on the driving signal a pulse width modulation (PWM) method, which consists (refer to Figure 2) in driving the different phases (typically three) of the motor, rather than with a continuous wave (represented with dots and lines in Figure 2), with a pulse train having a duty cycle, that is, a ratio start up time tₒₙ to period tₒₙ + t_{off}, typically of 50%. In this way, as it can be seen, the current absorbed by motor 10 - power supply voltage being equal-, and the consumption of the laser module 1 accordingly, is reduced by a factor equal to the duty cycle. With this provision, as yet not used for driving laser modules although per se known in large-size motors, the consumption of the laser module 1 is lower than 70 mA when at operating power. Due to the very low inertia of the polygonal mirror 9, the torque reduction of motor 10 resulting from the use of this powering method, does not affect the performances described so far.

The use of the polygonal mirror 9 as the optically reflecting member allows obtaining a scan on a very wide angle. For example, an octagonal-base body with outer diameter D_{S} of 7 mm struck by a laser beam of 0.6 mm in diameter, allows a useful scan of 62°, a hexagonal-base body with the same outer diameter D_{S} and with the same incident beam allows a useful scan of 91°, and so on. Theoretically, in fact, an N-faced polygon allows covering an optical angle of 360*2/N degrees. In practice, this angle is smaller since the laser spot, at the end of each face of the polygonal mirror, is truncated and "split" between two adjacent faces, thus producing a pair of spots not usable individually for reading purposes. As it shall be better explained hereinafter, such a pair of laser spots can however be used for aiming the code.

Of course, decreasing the number of faces -the diameter being equal- it is possible to increase the angular amplitude of the scan, thus reaching a particular width of the scan line at a smaller distance, that is, moving forward the motor towards the output window for further reducing the depth of the laser module 1. Of course, when decreasing the number of faces of the polygonal mirror 9, it is necessary to increase the revolving speed of motor 10 for obtaining an equal number of scans per time unit.

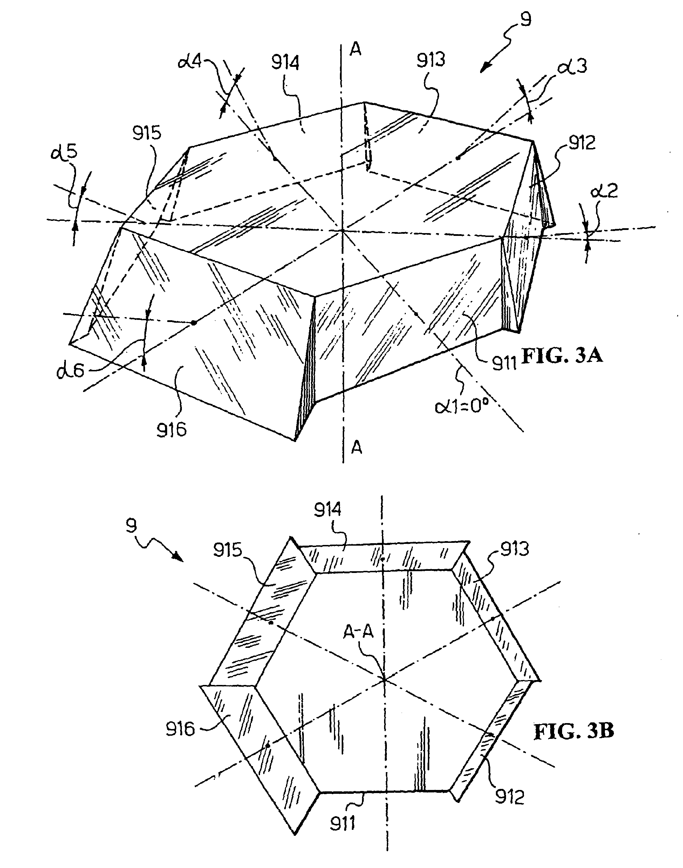

Should in a specific application stacked optical codes be read, that is, consisting of more stacked linear codes, it is convenient to produce a series of superimposed parallel scan lines, that is, which cover an area (raster). This can be obtained by sloping the single faces of the polygonal-base body (optically reflecting member 9) at different angles with respect to the axis. Figures 3A and 3B respectively show a perspective and a plan view of an optically reflecting member 9 with hexagonal base, whose first side face 911 is not sloping (α1=0) and whose other side faces 912-916 are sloping at a respective angle, increasing from α2 to α6, with respect to axis A-A. For convenience, angles α2-α6 are indicated in Figure 3A between the normal to the surface of the respective face, and the normal to the axis. Of course, the faces may have differently ordered slopes, or they could be sloping around a median plane rather than around the top plane as shown in Figures 3A and 3B.

Before describing the receiving section of the laser module 1 of Figure 1, it is worth noting that the optically reflecting member 9 may consist of a plane mirror or, more in general, of a single reflecting surface, in such cases motor 10 being driven so as to move the optically reflecting member 9 with an alternately oscillating motion along a circumference arc subtending an angle in the above ranges. For reading stacked codes, the bidimensional scan can be easily obtained by providing the possibility of a second movement of such an optically reflecting member around an axis orthogonal to the axis of the above oscillating motion.

In an optically reflecting member 9 (polygonal mirror or plane mirror) with such a small size, selected for obtaining the smallest rotating mass, the size of the or each reflecting surface is a little greater than that of the laser spot incident thereon, therefore it is not suitable to collect enough light for generating a significant return signal. A receiving section that does not exhibit components in common with the scanning illumination section, and which exhibits a front surface for collecting the light diffused by the optical code much greater than those of known laser modules, may therefore be used. More precisely, the two sections are spatially distinct, that is to say, they are such that the illumination laser light and the light diffused by the code follow totally separate paths.

The components of the receiving section of the laser module 1 shown in Figure 1 comprise a receiving window 20 obtained in the front wall 3, a glass 21, a focusing lens 22, a slit 23 and at least one photo-detecting element 24, in Figure 1 there being shown four photodiodes 24 by way of an example. However, glass 21 and slit 23 may be omitted. All the above elements are arranged in the upper portion of the laser module 1, above the emission window 11, there being also provided a horizontal wall (not shown) for separating the receiving section from the scanning illumination section described above.

More in particular, glass 21 is arranged at the receiving window 20 and the focusing lens 22 is arranged immediately behind it, so as to face the code C to be read through the receiving window 20.

On the other hand, the photo-detecting elements 24 and the optional slit 23 are retrocessed towards the rear wall 4 of module 1 up to the position of maximum depth allowed by the space taken up by motor 10. This allows using a receiving optics with the maximum aperture (f/#, that is, ratio focal length to lens diameter) and the maximum focal length, so as to maximise the return signal and reduce its dynamics. In fact, as known, the return signal on the photo-detecting elements 24 varies with the inverse of the square of the distance from the optical code. For this reason, it is necessary that the maximum amount of light is collected at the maximum distance. It is thus necessary that the aperture (collecting front surface) of the focusing lens 22 is the maximum. On the other hand, it is preferable that the collected signal is maximum from a long distance, but from a short distance, where the return signal is much higher, the quantity of collected light must be much smaller. By way of an example, under the assumption that lens 22 concentrates all the light diffused by the code both from a long distance and from a short distance, for a maximum reading distance of 50 cm and a minimum of 5 cm, the ratio close-signal to far-signal is equal to (50/5) ²=100:1, such as to saturate the dynamics of a typical amplification circuit. A long-focal lens 22 perfectly focuses only when the code is at the maximum distance, while as the code is brought closer, the image is increasingly out-of-focus, so that an increasingly greater energy fraction falls out of the photodiode sensitive area. In the laser module 1, the focal length must be comprised between 6 and 10 mm, for maintaining the depth of module 10 at a maximum of 10 mm. This is advantageous since it reduces the dynamics of the signal on the amplifier to acceptable values, which in the above example is from 2:1 to 3:1.

The focusing lens 22 used in the receiving section can be spherical, diffractive, or preferably toric, or cylindrical. A toric or cylindrical lens, in fact, provides a field of view that is wide along the scan line, and narrow in the direction orthogonal thereto, thus, in the application here concerned, it allows obtaining a high rejection to ambient light.

Lens 22 is preferably a Fresnel cylindrical lens, since its flat shape makes its assembling particularly simple. Moreover, such a lens can operate up to a ratio focal length to lens diameter f/#=1, a condition in which a traditional lens is affected by considerable reflections on the surface. This solution allows assembling the lens essentially in the receiving window 20 or contacting glass 21, thus further increasing the collection efficiency, because there is no shielding of lens 22 by receiving window 20 or glass 21.

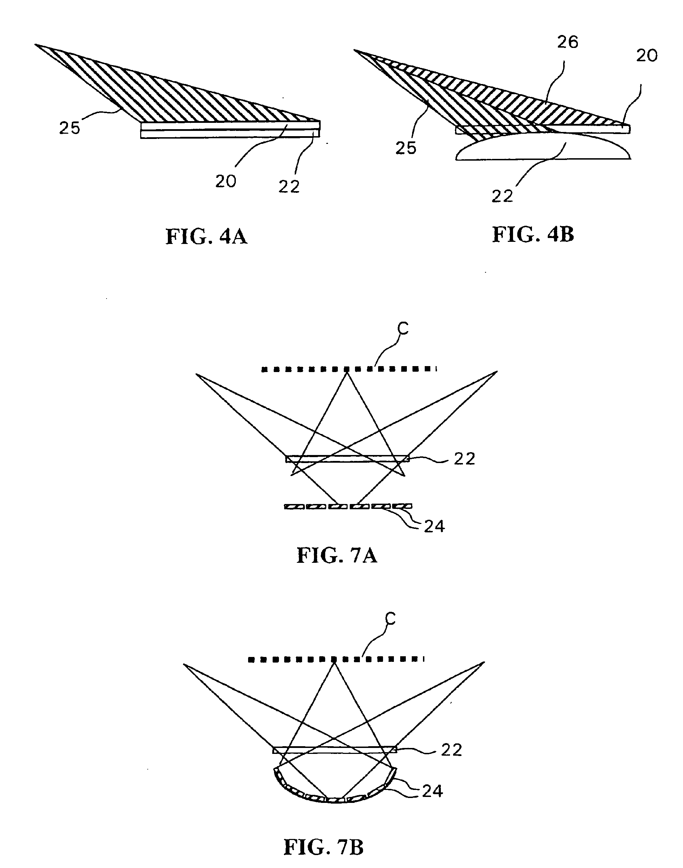

Figures 4A e 4B graphically show how the collected light fraction 25 in the case of a Fresnel cylindrical lens 22 (Fig. 4A) is much greater than in the case of a cylindrical or toric lens 22 (Fig. 4B), in which there is a considerable lost fraction 26.

Glass 21 of the receiving section can incorporate a filter for the purpose of reducing the noise produced by ambient light. Such a filtering glass 21 can be of the traditional type, that is, a coloured glass provided with a low-pass treatment, for example a red filter treated so as to absorb the infrared wavelengths, that is to say, higher than that of the laser radiation assumed to be red.

Lens 22 can be made of a coloured plastic material with high-pass behaviour. In this case, glass 21 can be transparent, with cost advantages, and it can serve as a protective element against the outside.

In a preferred way, moreover, there will be present a low-pass treatment, created on the transparent glass 21, or on the optically non-active face of the lens 22 itself.

In both cases, the overall cost of lens 22 and glass 21 is reduced by about one third with respect to the case of transparent lens 22 and coloured glass 21.

For minimising the possibility that light coming from an area external to the field of view lens 22, that is to say, from an area external to the scan line on the optical code, may reach the photo-detecting elements 24 of the receiving section, they are arranged - as already mentioned - as backwards as possible in the laser module 1 with respect to the receiving window 20.

The expediency of such an arrangement can be better appreciated by comparing Figure 5A with Figure 5B, which represents the prior art. In fact, it can be noted that in the arrangement of Figure 5A, the rays coming from areas external to the field of view fall outside the sensitive area of the photo-detecting elements, here represented by a single photodiode 24. On the other hand, by arranging photodiode 24 immediately behind lens 22, as shown in Figure 5B, it is also reached by sloping rays, which merely introduce noise, as they do not come from the area where the optical code C to be read is.

Since a toric or cylindrical lens forms at the focus an image which is in turn a line as wide as the lens, and very thin, photodiode 24 preferably exhibits a wide and short sensitive area, for example having an height H_{F} less than 1.5 mm and a width L_{F} equal to the maximum width available in the laser module 1 (between 20 and 25 mm), and of course it is arranged at the focus of lens 22. In the schematic view of Figure 5A, the dotted line shows an essentially parallelepiped deceiving chamber 27, whereas the optional elements of the receiving section, that is, the protective and/or filtering glass 21 and slit 23, are not indicated.

For obtaining such geometrical features, as an alternative to a single photodiode it is possible to use a bank or array of single photo-detecting elements (for example, small photodiodes), as already illustrated in Figure 1.

For selecting with greater precision the overall sensitive area interested by the light collection and/or further reducing the field of view, it is advantageous to arrange, in front of the photo-detecting elements 24, irrespectively of how they are made (single element or array), a wide and low slit 23, as already illustrated in Figure 1.

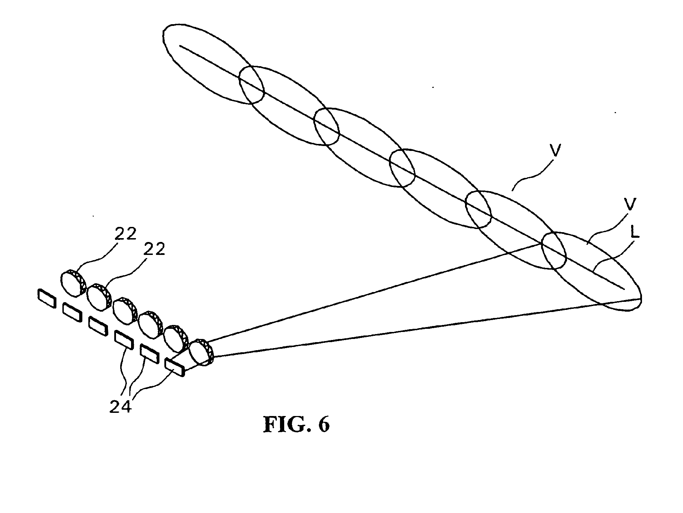

As shown in Figure 6, in the case of an array of photo-detecting elements 24, it can be convenient to use, for the focusing, a corresponding array of focusing lenses 22, for example spherical, toric, cylindrical, optionally Fresnel lenses. In this way, the field of view V of each photo-detecting element 24 only includes a portion of the scan line L on the optical code (not shown). The field of view V of each photo-detecting element 24 is oval-shaped in Figure 6, but of course the actual shape of the field of view V of each photo-detecting element 24 will depend on the shape of the photo-detecting element itself (square, rectangular, or circular) and on the shape of lenses 22.

Moreover, if an array of photo-detecting elements 24 is used in reception, it is preferred to arrange them with respect to lens or lenses 22 in such a way as to allow increasing both the return signal and the angle of view of the reader. As it can be appreciated from Figure 7A, if the photo-detecting elements 24 are arranged in a row in a plane parallel to the plane containing lens or lenses 22, the light coming from the edges of the field of view (that is to say, from the edges of the optical code C) strikes the side walls of the laser module 1 or of a receiving chamber 27 thereof, housing the components of the receiving section, and it is lost in any case. By arranging one or more photodiodes in a lateral position, for example close to the side walls of the receiving chamber 27, or even arranging the photo-detecting elements 24 along a curve, as in Figure 6B, it is possible to recover also this portion of signal, thus increasing the collection efficiency of the system. In particular, the curve shall correspond to the optimum focus curve in the case of a single focusing lens 22.

By combining this solution with that previously described, that is, to an arrangement of photodiodes 24 as retrocessed as possible in the laser module 1, it is possible to increase the received signal without increasing the noise due to ambient light.

In this respect, a further expedient consists in using a stepping motor 10 whose motion is synchronised with the actuation of the photo-detecting elements 24 of the array. Since in any instant the position of the motor is known by being established by the control circuit, the laser spot position is accordingly known, so that it is possible to actuate only the particular photo-detecting element 24 of the array being struck by the light diffused by the code, with self-evident energy and signal/noise ratio advantages.

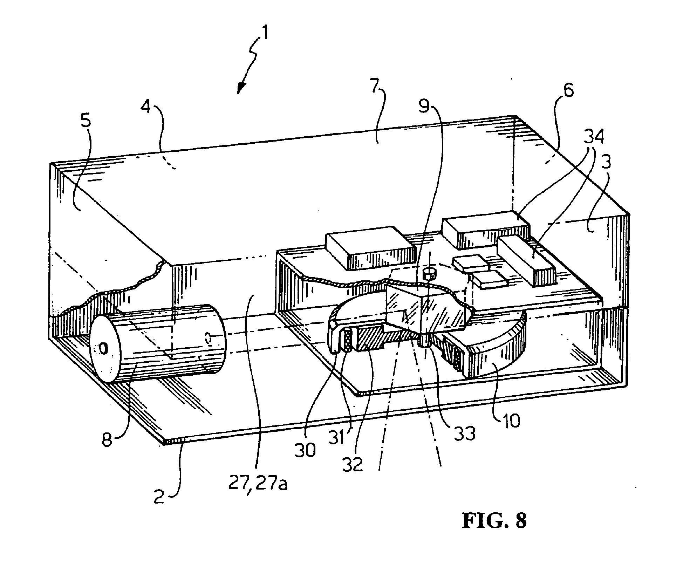

In Figure 8, motor 10 has an extremely small thickness, having a height H_{M} less than 3 mm, and such as to retain a limited plan extension, typically within a square of 20 mm X 20 mm or less. In Figure 8 it is possible to see the motor casing or stator 30, windings 31, magnet or rotor 32, the motor shaft 33 and the electronic components 34 for driving motor 10.

The small overall dimensions mentioned for motor 10 can be obtained by a great reduction of the size of a traditional stepping or brushless motor. This implies the need of reducing the size of magnets 32 and of windings 31, but it still allows obtaining a sufficient torque from the motor, provided that the mass of the polygonal mirror 9 (or other optically reflecting member) assembled on it is sufficiently small.

As regards the driving of motor 10, the above mentioned remarks apply, that is, it shall preferably occur with pulse width modulation, with continuously variable speed, and preferably with a ramp upon start up.

Moreover, in Figure 8 it is possible to see the optically reflecting member, illustrated as a polygonal mirror 9, and the laser source 8, whereas there are not shown the components of the receiving section, schematically illustrated as a chamber 27 (dotted lines) housed above the scanning illumination section. Of course, as an alternative, the receiving section may be housed under the scanning illumination section. In any case, all the above remarks apply to these components. It shall then be understood that the arrangement of Figure 8 allows the photo-detecting elements 24 of the receiving section to be further retrocessed towards the rear face 4 of laser module 1, thus increasing the shielding effect of the field of view of lens 22 and allowing to increase its focal length, thus improving the signal dynamics, as described above.

Also as regards the particular elements of the scanning illumination section other than motor 10, the above remarks apply. In particular, the polygonal mirror 9 may be replaced by a plane mirror or in any case one exhibiting a single reflecting surface, and the laser light provided by emitter 8 may be modulated at high frequency, in particular for the purpose of making a laser reader capable of measuring the distance of the optical code C.

Moreover, also in the case of Figure 8, the positions of motor 10, of laser emitter 8 and of optically reflecting member 9 are preferably fixed through conjugate means between such elements and the casing of the laser module 1.

In place of the internal-magnet motor 10 shown in Figure 8, it is possible to use a rotating magnetic disk motor. Such a motor is not shown, but it is structurally almost identical to the flat motor of Figure 8, with the exception that the magnets are outside the motor and they are energised by windings in which an alternate current is circulated, which generates a moment which forces the magnetic disk in rotation. Such a solution allows assembling the optically reflecting member 9 integral with the magnetic disk, for example inserted along shaft 33, thus obtaining a very small thickness. Moreover, it is possible to keep the size of the receiving chamber 27, that is, the mutual positions of the components of the receiving section, as well as the position of laser emitter 8 and the width of the scan line at the emission window 11, as described above.

Moreover, the electronic components 34 for controlling motor 10 can be assembled on its upper plate, together with an optional shielding against electromagnetic noise caused by powering the same motor, thus improving the efficiency of the amplification circuits of the received signal. The thickness only increases by at most 1-1.5 mm.

For scanning the laser beam generated by the laser emitter 8 it is also possible to use an optically reflecting member 9 with a single surface, and a motor consisting of an oscillating magnetic device, which exhibits the advantage of having a very small thickness.

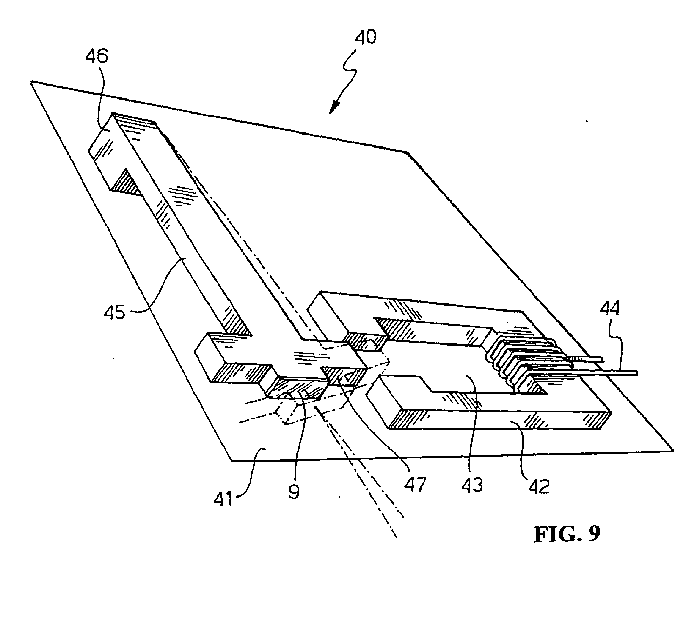

Such an oscillating magnetic device 40, which is based on the principle described for example in UETP MEMS -Ca Project- Course Micro Actuators, 1997, B.Schmidt, J.Fluitman, pages 3-7, 3-8, is schematically shown in Figure 9.

The oscillating magnetic device 40 exhibits, on an insulating substrate 41, for example made of ceramic, a core 42 made of a magnetic material, for example of Nickel-Iron, having a "C" shape, that is, exhibiting an air gap 43. On core 42 a winding 44 made of copper or other conductive material is made, for example in the manner described in B.Rogge, J.Schulz, J.Mohr, A.Thommes, "Magnetic Microactuators Fabricated by the LIGA-Technique for Large Displacements or Large Forces", Proc. Actuator '96, Bremen, pages 112-115, or in Chong H.Ahn, Mark G.Allen, "A fully integrated Surface Micromachined Magnetic Microactuator with a Multilevel Meander Magnetic Core", Journal of MEMS, 2, pages 15-22, 1993.

Moreover, the oscillating magnetic device 40 exhibits an elongated magnetic element 45. The magnetic element 45 is essentially T-shaped, and is integral with substrate 41 at the end 46 of the T stem. The T-shaped magnetic element 45 is arranged in such way with respect to the magnetic core 42 that an end 47 of the T top-line is in the proximity of the air gap 43 of the magnetic core 42 when winding 44 is not energised (rest position), but is attracted to the air gap 43 when winding 44 is energised, as shown in Figure 9 with dotted line. More in particular, the elongated magnetic element 45 is a resonant structure that, energised with a forcing wave having a frequency equal or close to its own frequency, vibrates at the above frequency.

At the T top-line there is applied the optically reflecting member 9, in this case a single mirror, in particular plane. Mirror 9 is thus made to oscillate for scanning the laser beam generated by the laser emitter 8.

Thanks to the possibility of making such structures with thickness down to a few mm, the oscillating magnetic device 40 shall actually exhibit a thickness equal to the mere size of the laser spot striking on mirror 9, which thus becomes the limiting element of any further reduction in the scan system thickness. Considering that such size ranges from a minimum of 0.5 to a maximum of 1.5 mm, and that substrate 41 can have a thickness of 0.5÷1.0 mm, the overall thickness of the scan means - comprising the oscillating magnetic device motor 40 and the plane mirror optically reflecting member 9 - of the entire scan motor is of just 1.0÷2.5 mm.

For scanning the laser beam generated by the laser emitter 8 it is also possible to use an electrostatic oscillating or rotary motor combined with an optically reflecting member 9 oscillating in the first case, rotating or oscillating in the second case.

A oscillating or rotating electrostatic motor basically consists of a capacitor, or of a series of capacitors, whose plates are alternately charged with opposed or equal polarities, so as to create an attractive/repulsive electrostatic force which cyclically tends to move them closer and apart. Through the particular capacitor plates, such a force causes a rotary or oscillating motion, as described and illustrated, in an exemplificative way, in the following publications: UETP MEMS -Ca Project- Course Micro Actuators, 1997, B.Schmidt, J.Fluitman, pages 3-1, 3-5; W.S.N. Trimmer and K.J.Gabriel, "Design considerations for a practical electrostatic micromotor", Sensors and Actuators, 11(1987), pages 189-206*;* S.Bart, M.Mehregany, L.S.Tavrow, J.H, Lang, S.S.Senturia, "Electric micromotors dymamics", IEEE Transactions on Electron Devices, 39(1992), pages 566-575 and H.Schenk, P.Dürr, H. Kück, "A novel electrostatically driven torsional actuator", proc. 3rd Intl. Conf. On Micro-Opto-Electro-Mechanical Sys., Mainz, Aug. 30th - Sept. 1st, 1999*.*

The means for scanning the laser beam generated by the laser emitter 8 can further consist of an electro-optical device or of an acousto-optical device.

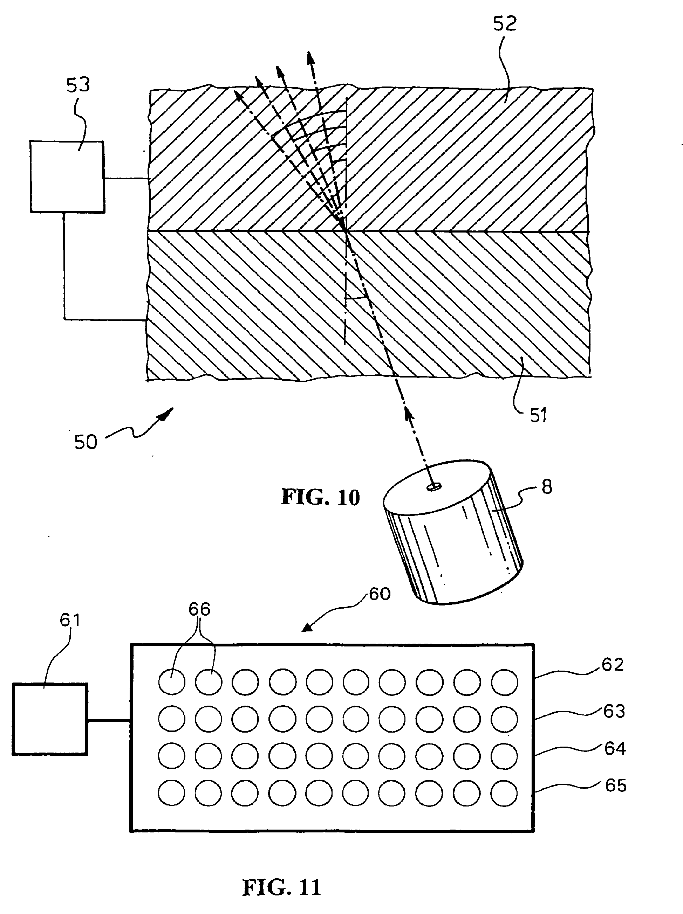

Such a scan means is schematically shown in Figure 10.

An electro-optical device 50 essentially comprises an interface between a first medium 51 and a second medium 52 (for example, two glass plates or air and a glass plate) and a circuit 53 for applying an electric field to the first and/or to the second medium. The electric field changes the refractive index of the medium it is applied to. The laser light beam generated by the laser emitter 8 and directed through the first medium 51 is thus deflected at the interface with the second medium 52 according to a controllable refraction angle. Figure 10 does not show, for simplicity, the refractions at the interfaces between the air and the first medium 51 and between the second medium 52 and the air.

An acousto-optical device is totally similar, except in that the refractive index of the first and/or the second medium is varied through acoustic energy.

Alternatively, there may be provided an array 60 of laser micro-sources and a controller 61 for driving the laser micro-sources. Figure 11 rather schematically shows an array comprising, by way of an example, four rows 62-65 of ten laser micro-sources 66 each.

Controller 61 sequentially actuates the laser micro-sources 66 of a row 62-65 of the array 60 for scanning the optical code with a laser spot, instant by instant generated by one of the laser micro-sources 66 of the driven row 62-65.

Even though a single row of laser micro-sources is therefore sufficient (for example, row 62), there are preferably present more rows - of course, the number of four in Figure 11 being purely exemplificative. In this way, it is thus possible to generate more scan lines at different heights in the optical code, in particular for reading stacked codes.

In a particularly advantageous way, moreover, in each row 62-65 the laser micro-sources 66 are of a different colour. Thus, for example, row 62 may generate a red laser light scan line, row 63 may generate a green laser light scan line, and so on. Controller 61 and the logics of the optical code reader in which the laser module is intended to be included may thus illuminate the optical code with the laser line of the most suitable colour for its reading, depending on the colour of the optical code itself, and of its background, for example depending on the space and bar colour of a bar code.

The laser micro-sources 66 of the array 60 shall be preferably arranged as close as possible to the rear wall 4 of the laser module 1 for the purpose of having a long scan line at the output of the emission window 11 for the reasons described above.

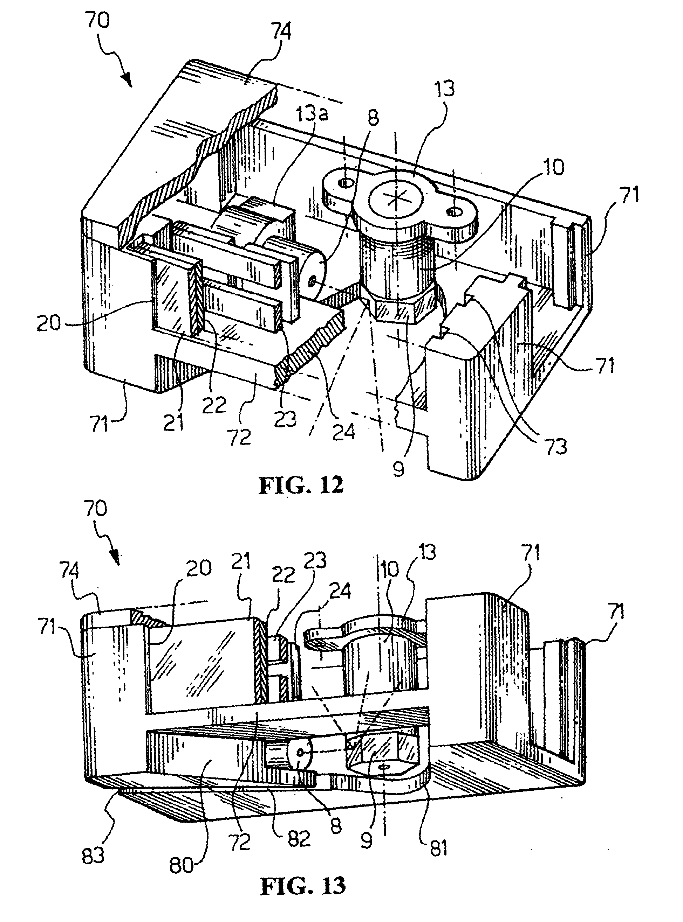

It will be now described, with reference to Figures 12 and 13, a block 70 particularly useful since it combines in a single moulded piece the support of both the receiving section components, and the scanning illumination section components. The support block 70 is illustrated with reference to the particular components of Figure 1, but, of course, it could be used after suitable modifications also for the other components described.

Firstly, the support block 70 exhibits peripheral vertical legs 71 and a horizontal partition 72. In the portion above partition 72, as it can be seen in the view of Figure 12, the peripheral front legs 71 exhibit a series of grooves 73 wherein there are inserted the optional protective and/or filtering glass 21, the focusing lens 22, the optional slit 23 and finally, the circuits on which the photo-detecting elements 24 are welded.

In practice, the receiving section is insulated from above thanks to a thin black flexible plastic sheet (not shown) which "rests" on the upper base of the support block 70 and is kept pressed on it by the pressure of the printed circuit 74 containing the electronic components.

According to the selected motor 10, it can be housed in the portion above partition 72 (as shown in Figures 12 and 13) or in the lower portion, for example in the case of motors having a smaller thickness, such as for example the magnetic disk motor or the oscillating magnetic device described above.

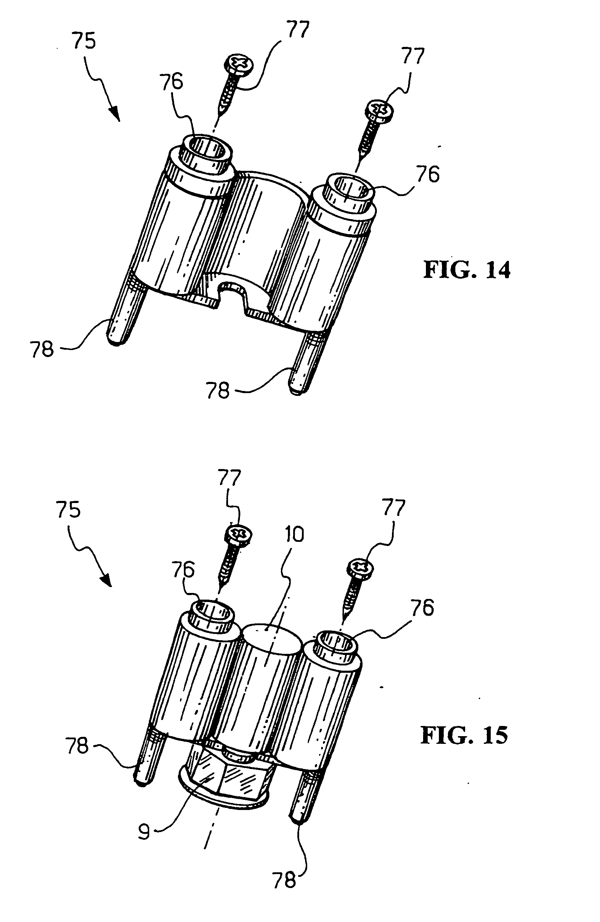

For the purpose of ensuring the placement of motor 10 and thus of the optically reflecting member 9 with respect to laser 8, both in height and in plan, it can be advantageous to provide, as an alternative to clip 13 shown in Figures 12 and 13, a bored cylindrical support 75 (Figures 14 and 15) in which the body of motor 10 may slide, said support 75 exhibiting threaded holes 76 for fastening it at one end of the upper printed circuit 74 through two screws 77 and, at the other end, being able to be introduced in two holes (not shown) properly provided in block 70, through two pins 78. In this way, the shocks are better absorbed since motor 10 is fastened in four points to the support block 70, and moreover, angular misalignments are prevented. Preferably, motor 10 is pressure fit into the support block 70, by using a carved structure so as to create a snap fit.

Turning back to Figures 12 and 13, in the portion below partition 72 of the support block 70 there are housed the laser emitter 8 and the optically reflecting member 9, for example the polygonal mirror shown. The latter is preferably arranged at the vertex of an essentially triangular recess defined by two vertical walls 80, 81, for the purpose of insulating the illumination laser light from the other components.

Advantageously, the lower portion of the support block 70 also exhibits a groove 82 which selects a part of the scan, carried out at a very great angle, and conveys it towards the sensitive area of a very small photodiode 83, used as a scan start sensor and for the feedback control of motor 10, as it will be better explained hereinafter. Optionally, the light collection can be facilitated by introducing in groove 82 a light guide (not shown), consisting for example of a plastic prism, such as to facilitate the coupling between the light reflected by the polygon and the sensitive area of the small photodiode 83. The end surface of such a light guide can be made diffusing (rough) for guaranteeing the coupling also in the presence of even quite considerable position errors of photodiode 83. There may be provided a second groove with a respective photodiode for detecting the scan end, as an alternative or in addition to groove 82 and photodiode 83 for detecting the scan start.

The provision of the extraction path defined by groove 82 and of the scan start photodiode 83, in se known in larger scanners, has the function of intercepting the end portion of the scan, which typically is not used since it corresponds to a very large angle, at which the laser spot falls in the middle between a face of the polygonal mirror optically reflecting member 9 and the subsequent one, or at the edge of a plane mirror. Thus, such a photodiode 83 provides a pulse for each scan, or "scan" signal, which allows synchronising the electronics on the single scan and is used, for example, by the decoder for starting to search an optical code within the scan line. Moreover, such a signal can be particularly useful for decoding systems based on reconstruction.

Of course, similar provisions can be implemented in the other described scanning illumination sections. For example, in the case of the array 60 of laser micro-sources, the scan start (end) signal shall correspond to the start up of the first (last) micro-source 66 of each row 62-65.

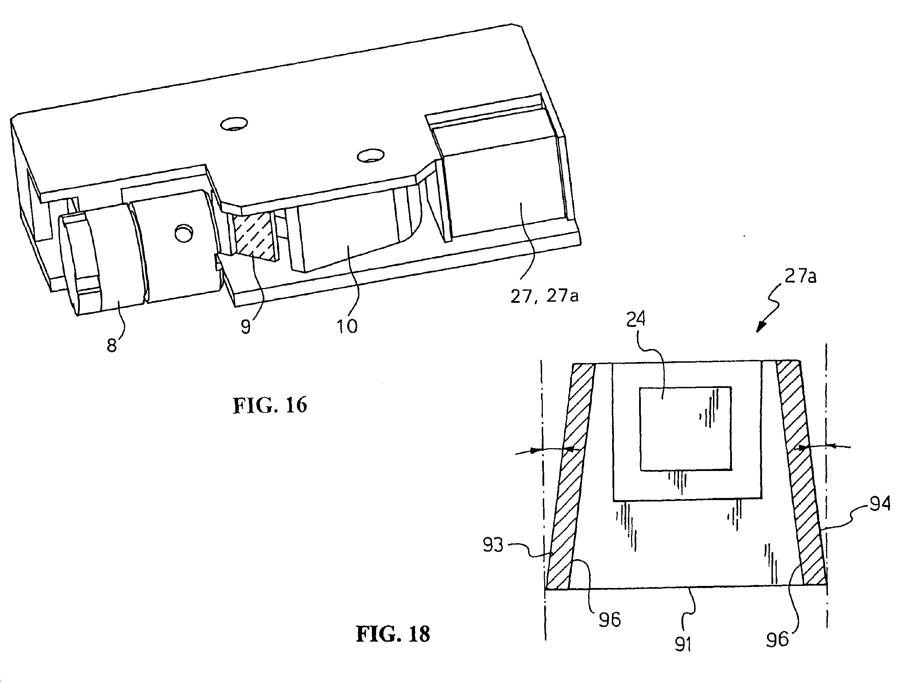

Figure 16 schematically shows a further laser module 1, in which the components of the scanning illumination section and those of the receiving section are arranged in a common plane, so that the laser module 1 has an extremely reduced thickness. In Figure 16, the scanning illumination section is illustrated as comprising a laser emitter 8, a plane mirror as the optically reflecting member 9 and a motor 10. However, such a single plane arrangement is also suitable for the other scanning illumination section described above. It can be noted that, in order to limit the length (that is to say, the size in the direction parallel to the scan line) of the laser module 1, the plane mirror 9 and the laser emitter 8 are arranged in the proximity of the front face of the laser module itself, mirror 9 being partly arranged in front of the motor.

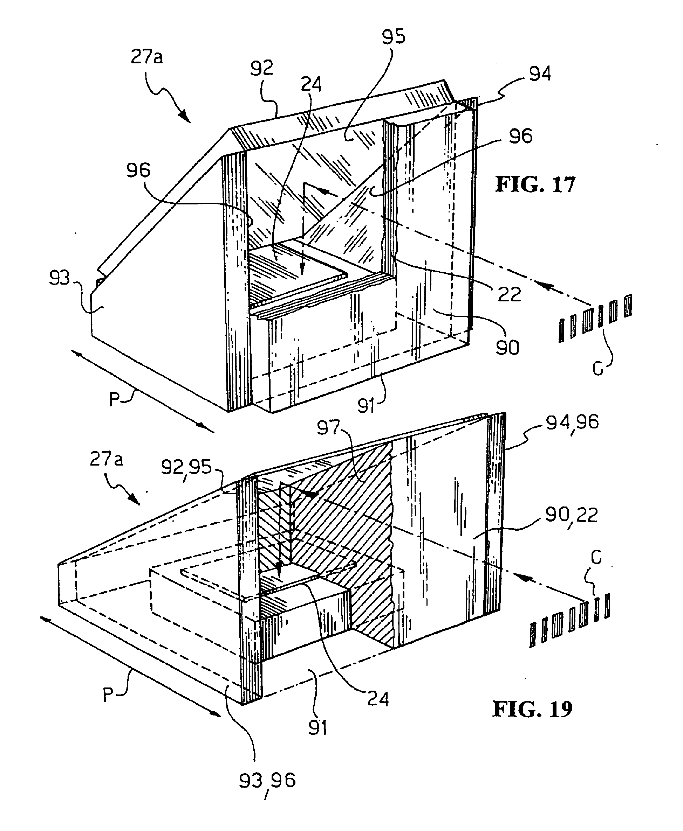

In Figure 16, the receiving section is schematically illustrated as the receiving chamber 27 or the receiving chamber 27a described hereinafter with reference to Figures 17-19. However, for further reducing the length of the laser module 1, the photo-detecting elements 24 may also be arranged in the proximity of the front face of the laser module, partly extending in front of motor 10 similarly to the arrangement of the plane mirror 9 of Figure 16.

Thus, with reference to Figure 17, the receiving chamber 27a is wedge-shaped, and it comprises a front face 90, a lower face 91 orthogonal to it, a sloping face 92 between them, and side faces 93, 94 shaped as right-angled triangles.

The focusing lens 22 (or the lens system) is arranged at the front face 90, whereas the photo-detecting elements 24 (or the single photodiode) are arranged at the lower face 91. The sloping face 92, having a maximum slope of 45° with respect to the front face 90, is provided with an internally reflecting surface 95. As shown by the dotted arrow, the rays of light diffused by code C penetrate the receiving chamber 27a from the front face 90, passing through lens 22 and arriving, through a horizontal path segment, on the internally reflecting surface 95 of the sloping face 92. At this internally reflecting surface 95, the rays of diffused light are reflected downwards, covering a second vertical segment towards the photo-detecting elements 24.

Such a wedge-shaped receiving chamber 27a allows using a lens having a longer focal length than a parallelepiped receiving chamber, depth size P being equal. A long focal length lens offers the advantages described above. From another point of view, focal length of lens 22 being equal, it is possible to make the receiving chamber 27a with a smaller depth P with respect to the receiving chamber 27, with advantages in terms of compactness of the laser module. Moreover, the horizontal arrangement of the photo-detecting elements 24 allows using a single commonly marketed photodiode, having a large area, without thus adversely affecting the thickness of the receiving chamber 27a and thus of the laser module 1. Moreover, the horizontal arrangement of the photo-detecting elements 24 prevents the need of providing a vertical printed circuit for their control and for receiving their output electrical signal, as it is otherwise necessary. On the contrary, on the same printed circuit there can also be provided the necessary components and connections for powering and controlling the scanning illumination section. Such a printed circuit may for example form the base of the laser module 1 of Figure 16.

For recovering also the light coming from the edges of the scan line of the optical code C, increasing the efficiency of light collection without increasing the noise due to ambient light, also the side faces 93, 94 of the receiving section 27a can be provided with internally reflecting surfaces 96.

For further improving the light collection efficiency, the side faces 93, 94 of the receiving section 27a can, moreover, be slightly converging away from the front face 91, as shown in the top view of Figure 18.

In Figure 17, the receiving chamber 27a is hollow, its faces 90, 92 and optionally, 93, 94, 91 respectively consisting of lens 22, mirrors 95, 96 and photodiode 24.

As an alternative, as shown in Figure 19, the receiving section 27a can consist of a block 97 of an optically transparent material shaped as a wedge in the manner described above, and having a mirror treatment on the sloping face 92 and optionally on the side faces 93, 94. In this way, the mutual orientation of the various faces is more easily controllable.

Although it has been described with reference to the arrangement in the same plane of the scanning illumination section components (Fig. 16), it is manifest that the above advantages of such a wedge-shaped receiving chamber 27a make its use advantageous also above or below the scanning illumination section, in this case the wedge-shaped receiving chamber 27a being preferably assembled upside down with respect to the orientation of Figures 17-19, that is with the lower face 91 arranged on the top, at the parting plane from the scanning illumination section.

In the practical use of the laser module 1 for reading optical codes of the present invention, it can be useful to allow the operator to aim at the optical code before starting the reading. This can be obtained by assembling the scanning optically reflecting member 9 in a predetermined position with respect to the shaft (rotation axis) of motor 10, so that, upon start up, by suitably driving motor 10, such an optically reflecting member 9 arranges in a predetermined position with respect to the incident laser beam.

All the rotary motors described above are characterised by the presence of a certain number of magnetic dipoles (at least one) on the rotating portion (rotor), and of a certain number of windings on the stator. It can be imagined to reduce the number of magnetic dipoles on the rotor to only one. Then, if upon start up only one of the stator windings is powered, with a direct current, the rotor arranges in a univocal position. Thus, it is possible to assemble the optically reflecting member in a predetermined position with respect to the rotor. Since the stator windings are also arranged in a predetermined position with respect to the outer casing and to the pins, it is also possible to assemble the motor on the printed circuit so that the windings are always in a predetermined position with respect to the printed circuit, and thus to the arrival direction of the laser beam. In more detail, the assembling operation can follow the sequence below.

The motor is assembled on the printed circuit with the pins oriented so that the windings are in a preset position with respect to the incident laser beam. Then, a winding is powered with direct current so that the rotor dipole aligns with the polarity of the powered winding. With the rotor in this angular position, the optically reflecting member is assembled with such an orientation as to produce a fixed spot at the centre of the scan line, or two spots at the edges of the scan line, in the case of a polygonal mirror mounted with an edge at the incident laser beam.

Once thus fastened, the optically reflecting member places itself in the same position every time the same winding is fed, thus allowing an effective aiming. For allowing such a stand-by of the laser source with respect to the actuation of the motor for scanning the laser beam, there can be provided independent actuation buttons, a single dual-position switch, or a preset delay. Moreover, it can be advantageous, for safety reasons, to provide for the automatic switching off of the laser in case the motor is not started within a predetermined time from the laser start up.

A similar provision can be easily embodied in the case of the other described scanning illumination sections. Thus, in the case of the magnetic oscillating device 40, the stand-by position can be established by the absence of powering in the winding; in the case of the electro-optical or acousto-optical devices 50, by the absence of driving of the same devices; in the case of the micro-sources array 60, by the start up of the central source or of the two end sources of a row.

Finally, in case an array of photo-detecting elements 24 of the C-MOS type is used, it is always possible to integrate all the sensor control logics, the digitising logics and the decoding logics on a same chip. In this way, the size and costs of the system can be further reduced.

For the purpose of reducing the number of components present, moreover, it will be also possible to provide a dedicated integrated circuit capable of totally digitally processing the signal produced by the photo-detecting elements 24. Such a circuit shall contain an analogue-to-digital converter for providing the sampled analogue signal to a digital processing circuitry. In this way, all the analogue components required for digitising are avoided, being replaced by a single dedicated digital chip.

For economical reasons and for simplicity of assembling, the same integrated circuit can contain all the circuits required for the motor control.

A further advantageous provision consists in producing, in an optical code reader in which the module laser 1 is embedded, a circuit capable of providing both the digitised output, needed for compatibility reasons with the products already existing on the market, and the decoded output. In this way, readers of very small size and low cost can be implemented.

## Claims

1. A receiving section for a laser reader, comprising a receiving chamber (27a) for collecting at least a portion of the light diffused by an optical code (C), having a light input face (90) at which at least one focusing lens (22) is arranged, a detection face (91) orthogonal to said light input face (90), and a sloping face (92) adjoining, at opposite edges thereof, said light input face (90) and said detection face (91), for internally reflecting said diffused light towards said detection face (91), and side faces (93, 94) each adjoining, at three edges thereof, said light input face (90), said detection face (91), and said sloping face (92).

2. The receiving section (27a) according to claim 1, **characterised in that** there is a slit (23) between said at least one focusing lens (22) and said detection face (91).

3. The receiving section (27a) according to any of the previous claims, **characterised in that** the slope angle between the sloping face (92) and the light input face (90) is less than 45 degrees.

4. The receiving section (27a) according to any of the previous claims, **characterised in that** also the side faces (93, 94) are for internally reflecting said diffused light towards said detection face (91).

5. The receiving section (27a) according to any of the previous claims, **characterised in that** the side faces (93, 94) are slightly converging away from the light input face (90).

6. The receiving section (27a) according to any of the previous claims, **characterised by** being solid, made of an optically transparent material (97).

7. The receiving section (27a) according to any of the previous claims, **characterised in that** said at least one focusing lens (22) is selected between a cylindrical lens and a toric lens.

8. The receiving section (27a) according to claim 7, **characterised in that** said at least one focusing lens (22) is a Fresnel cylindrical lens.

9. The receiving section (27a) according to any of the previous claims, **characterised in that** said at least one focusing lens (22) is made of a coloured plastic material with high-pass filter behaviour.

10. The receiving section (27a) according to any of the previous claims, **characterised by** comprising a common glass filter (21) having a low-pass treatment.

11. The receiving section (27a) according to any of the previous claims, **characterised in that** the focusing lens (22) is coloured with low-pass filter behaviour on its optically non-active face.

## Patentansprüche

1. Empfangsstation für eine Laser-Lesevorrichtung mit einer Empfangskammer (27a) zum Erfassen wenigstens einen Teils des von einem optischen Code (C) gestreuten Lichtes, mit einer Lichteingangsfläche (90), an der wenigstens eine Fokussierlinse (22) angeordnet ist, einer Erfassungsfläche (91), die zu der Lichteingangsfläche (90) orthogonal ist, und einer geneigten Fläche (92), welche an deren einander gegenüberliegenden Rändern an die Lichteingangsfläche (90) und die Erfassungsfläche (91) angrenzt, zur internen Reflektion des in Richtung der Erfassungsfläche (91) gestreuten Lichtes, und Seitenflächen (93, 94), welche jeweils an drei Kanten dieser Flächen an die Lichteingangsfläche (90), die Erfassungsfläche (91) und die geneigte Fläche (92) angrenzen.

2. Empfangsabschnitt (27a) nach Anspruch 1, **dadurch gekennzeichnet, dass** ein Schlitz (23) zwischen der wenigstens einen Fokussierlinse (22) und der Erfassungsfläche (91) vorgesehen ist.

3. Empfangsabschnitt (27a) nach einem der vorangehenden Ansprüche, **dadurch gekennzeichnet, dass** der Neigungswinkel zwischen der geneigten Fläche (92) und der Lichteingangsfläche (90) weniger als 45° beträgt.

4. Empfangsabschnitt (27a) nach einem der vorangehenden Ansprüche, **dadurch gekennzeichnet, dass** auch die Seitenflächen (93, 94) für die interne Reflektion des in Richtung der Erfassungsfläche (91) gestreuten Lichtes vorgesehen sind.

5. Empfangsabschnitt (27a) nach einem der vorangehenden Ansprüche, **dadurch gekennzeichnet, dass** die Seitenflächen (93, 94) mit zunehmendem Abstand von der Lichteingangsfläche (90) leicht konvergieren.

6. Empfangsabschnitt (27a) nach einem der vorangehenden Ansprüche, **dadurch gekennzeichnet, dass** er ein Vollkörper ist, der aus einem optisch transparenten Material (97) besteht.

7. Empfangsabschnitt (27a) nach einem der vorangehenden Ansprüche, **dadurch gekennzeichnet, dass** die wenigstens eine Fokussierlinse (22) eine zylindrische oder eine torische Linse ist.

8. Empfangsabschnitt (27a) nach Anspruch 7, **dadurch gekennzeichnet, dass** die wenigstens eine Fokussierlinse (22) eine zylindrische Fresnel-Linse ist.

9. Empfangsabschnitt (27a) nach einem der vorangehenden Ansprüche, **dadurch gekennzeichnet, dass** die wenigstens eine Fokussierlinse (22) aus einem eingefärbten Kunststoffmaterial hergestellt ist, welches ein Hochpassfilter-Verhalten aufweist.

10. Empfangsabschnitt (27a) nach einem der vorangehenden Ansprüche, **gekennzeichnet durch** einen Filter (21) aus üblichem Glas mit einer Tiefpass-Behandlung,

11. Empfangsabschnitt (27a) nach einem der vorangehenden Ansprüche, **dadurch gekennzeichnet, dass** die Fokussierlinse (22) auf ihrer optisch nichtaktiven Fläche zum Breichen eines Tiefpassfilter-Verhaltens eingefärbt ist.

## Revendications

1. Une section de réception pour un lecteur laser, comprenant une chambre de réception (27a) pour collecter au moins une partie de la lumière diffusée par un code optique (C), ayant une face d'entrée de lumière (90) sur laquelle au moins une lentille de focalisation (22) est agencée, une face de détection (91) orthogonale à ladite face d'entrée de lumière (90), et une face inclinée (92) attenante, sur des cotés opposés de celle-ci, à ladite face d'entrée de lumière (90) et à ladite face de détection (91), pour réfléchir en interne ladite lumière diffusée vers ladite face de détection (91), et des faces latérales (93, 94) chacune attenante, sur trois cotés de chacune, à ladite face d'entrée de lumière (90), à ladite face de détection (91), et à ladite face inclinée (92).

2. La section de réception (27a) selon la revendication 1, **caractérisée en ce qu'**il y a une fente (23) entre ladite au moins une lentille de focalisation (22) et ladite face de détection (91).

3. La section de réception (27a) selon l'une quelconque des revendications précédentes, **caractérisée en ce que** l'angle d'inclinaison entre la face inclinée (92) et la face d'entrée de lumière (90) est inférieur à 45 degrés.

4. La section de réception (27a) selon l'une quelconque des revendications précédentes, **caractérisée en ce que** les faces latérales (93, 94) sont également agencées pour réfléchir en interne ladite lumière diffusée vers ladite face de détection (91).

5. La section de réception (27a) selon l'une quelconque des revendications précédentes, **caractérisée en ce que** les faces latérales (93, 94) convergent légèrement en s'éloignant de la face d'entrée de lumière (90).

6. La section de réception (27a) selon l'une quelconque des revendications précédentes, **caractérisée en ce qu'**elle est solide, faite en un matériau optiquement transparent (97).

7. La section de réception (27a) selon l'une quelconque des revendications précédentes, **caractérisée en ce que** ladite au moins une lentille de focalisation (22) est sélectionnée parmi une lentille cylindrique et une lentille torique.

8. La section de réception (27a) selon la revendication 7, **caractérisée en ce que** ladite au moins une lentille de focalisation (22) est une lentille cylindrique de Fresnel.

9. La section de réception (27a) selon l'une quelconque des revendications précédentes, **caractérisée en ce que** ladite au moins une lentille de focalisation (22) est faite en un matériau plastique coloré ayant un comportement de filtre passe-haut.

10. La section de réception (27a) selon l'une quelconque des revendications précédentes, **caractérisée en ce qu'**elle comprend un filtre courant en verre (21) ayant un traitement passe-bas.

11. La section de réception (27a) selon l'une quelconque des revendications précédentes, **caractérisée en ce que** la lentille de focalisation (22) est colorée avec un comportement de filtre passe-bas sur sa face optiquement non active.
